# EUROPEAN PATENT SPECIFICATION

(11) **EP 0 665 646 B1**
(45) Date of publication and mention of the grant of the patent: **31.03.1999**
(21) Application number: 95100993.5
(22) Date of filing: 25.01.1995
(51) Int. Cl.: H03H 11/04

(54) **Filter circuit**
Filterschaltung
Circuit de filtrage

(30) Priority: 26.01.1994 JP 6958/94
(43) Date of publication of application: 02.08.1995
(73) Proprietor: SANYO ELECTRIC Co., Ltd., Moriguchi-shi, Osaka 570 (JP)
(72) Inventor: Hosoya, Nobukazu, Ikoma-gun, Nara (JP)
(74) Representative: Glawe, Delfs, Moll & Partner

(56) References cited:
- US-A- 5 001 441
- PATENT ABSTRACTS OF JAPAN vol. 13 no. 243 (E-768) ,7 June 1989 & JP-A-01 044615 (TOSHIBA) 17 February 1989,
- FREQUENZ, vol. 34,no. 10, October 1980 BERLIN DE, pages 288-291, A.M. SOLIMAN 'Novel Grounded C-Biquad Circuits Using the DVCCS/DVCVS'

## Description

### BACKGROUND OF THE INVENTION

### Field of the invention

The present invention generally relates to a filter circuit. More specifically, the present invention relates to a filter circuit including a first integrator to which a first input and a fed-back input are inputted, and a second integrator to which an output of the first integrator and a fed-back input are inputted.

### Description of the prior art

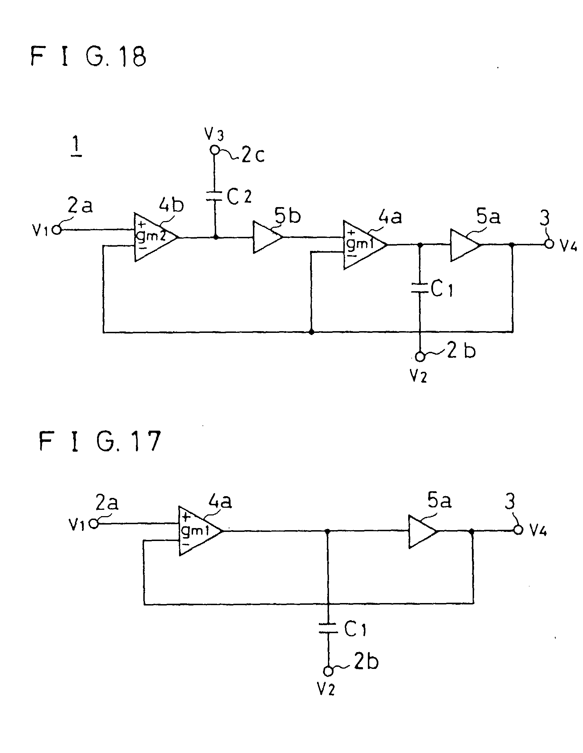

With referring Figure 17, a conventional filter circuit 1 includes an output terminal 3 from which a signal obtained through a filtering process of a signal inputted from one of input terminals 2a and 2b is outputted. On the assumption that inputs from the input terminals 2a and 2b are V₁ and V₂, respectively, and an output of the output terminal 3 is V₄, and a mutual conductance of a differential amplifier 4a is gₘ₁, the output V₄ is representative by the following equation 1. In addition, at a stage succeeding to the differential amplifier 4a, a buffer 5a is arranged.${\text{V}}_{\text{4}} \text{=} \frac{\text{S ·} \frac{{\text{C}}_{\text{1}}}{{\text{g}}_{\text{m1}}} {\text{· V}}_{\text{2}} {\text{+ V}}_{\text{1}}}{\text{S ·} \frac{{\text{C}}_{\text{1}}}{{\text{g}}_{\text{m1}}} \text{+ 1}}$

Furthermore, in view of the above described equation 1, a resonance frequency ω _{_{0̸}} can be represented by the following equation 2.${\text{ω}}_{\text{0̸}} \text{=} \frac{{\text{g}}_{\text{m1}}}{{\text{C}}_{\text{1}}}$

Furthermore, in Figure 18, another conventional filter circuit 1 is shown. The filter circuit 1 shown in Figure 18 is a filter in which a differential amplifier 4b having a mutual conductance of gₘ₂ and a buffer 5b are inserted between the input terminal 2a and the differential amplifier 4a of the filter circuit 1 shown in Figure 17, and an output of the buffer 5a is fed-back to the differential amplifier 4b, and an input terminal 2c is connected to a connection point of the differential amplifier 4b and the buffer 5b via a capacitor C₂. In this case, when an input from the input terminal 2c is V₃, the output V₄ can be represented by the following equation 3.${\text{V}}_{\text{4}} \text{=} \frac{{\text{S}}^{\text{2}} {\text{V}}_{\text{2}} \text{+ S ·} \frac{{\text{g}}_{\text{m1}}}{{\text{C}}_{\text{1}}} {\text{V}}_{\text{3}} \text{+} \frac{{\text{g}}_{\text{m1}} {\text{· g}}_{\text{m2}}}{{\text{C}}_{\text{1}} {\text{· C}}_{\text{2}}} {\text{V}}_{\text{1}}}{{\text{S}}^{\text{2}} \text{+ S ·} \frac{{\text{g}}_{\text{m1}}}{{\text{C}}_{\text{1}}} \text{+} \frac{{\text{g}}_{\text{m1}} {\text{· g}}_{\text{m2}}}{{\text{C}}_{\text{1}} {\text{· C}}_{\text{2}}}}$

In addition, a resonance frequency ω_{0̸} and a quality factor Q are represented by the following equations 4 and 5, respectively.${\text{ω}}_{\text{0̸}} \text{=} \sqrt{\frac{{\text{g}}_{\text{m1}} {\text{· g}}_{\text{m2}}}{{\text{C}}_{\text{1}} {\text{· C}}_{\text{2}}}}$$\text{Q =} \sqrt{\frac{{\text{g}}_{\text{m2}} {\text{· C}}_{\text{1}}}{{\text{g}}_{\text{m1}} {\text{· C}}_{\text{2}}}}$

In the filter circuit 1 shown in Figure 17, in order to make the resonance frequency low, as seen from the equation 2, it is necessary to make the mutual conductance gₘ₁ small and a capacity of the capacitor C₁ large. However, if the mutual conductance gmi is made small, it is necessary to operate a transistor included in the differential amplifier 4a in a region where a current amount of the transistor is small, and therefore, a frequency characteristic of the transistor becomes bad, and it becomes difficult to operate the transistor in a region where an S/N is large. Furthermore, if the capacity of the capacitor C₁ is made large, a chip area of an integrated circuit becomes large. Accordingly, it was difficult to set the resonance frequency low in the integrated circuit. Such a problem also occurs in the filter circuit 1 shown in Figure 18.

A filter circuit with differential amplifier and capacitor in which the problem of large time constant obtained using small capacitor is addressed is known from Patent Abstracts of Japan, vol. 13, no. 293 (E-768) and JP-A-1 044 615.

### SUMMARY OF THE INVENTION

Therefore, a principal object of the present invention is to provide a filter circuit in which a resonance frequency can be made low without making a capacity of a capacitor large.

A filter circuit according to the present invention is defined in the appended claim 1, with advantageous embodiments defined in dependent claims 2-7.

By arranging a transistor which attenuates a current by 1/β (β is a current amplification factor) at a stage succeeding to a differential amplifier having a mutual conductance of gₘ₁, for example, a term of gₘ₁ included in a numerator of an equation representing a resonance frequency ω_{0̸} is decreased by 1/β times.

In accordance with the present invention, only by arranging the current attenuation means, even if the capacity of the capacitor is not made large, it is possible to make the resonance frequency of the filter circuit low. In other words, if the same frequency, it is possible to make the capacity of the capacitor small.

The above described objects and other objects, features, aspects and advantages of the present invention will become more apparent from the following detailed description of the present invention when taken in conjunction with the accompanying drawings.

### BRIEF DESCRIPTION OF THE DRAWINGS

Figure 1 is a block diagram showing one embodiment according to the present invention;
Figure 2 is a circuit diagram showing Figure 1 embodiment;
Figure 3 is a block diagram showing another embodiment according to the present invention;
Figure 4 is a circuit diagram showing Figure 3 embodiment;
Figure 5 is a block diagram showing another embodiment according to the present invention;
Figure 6 is a circuit diagram showing Figure 5 embodiment;
Figure 7 is a block diagram showing another embodiment according to the present invention;
Figure 8 is a circuit diagram showing Figure 7 embodiment;
Figure 9 is a block diagram showing another embodiment according to the present invention;
Figure 10̸ is a circuit diagram showing Figure 9 embodiment;
Figure 11 is a block diagram showing another embodiment according to the present invention;
Figure 12 is a circuit diagram showing Figure 11 embodiment;
Figure 13 is a block diagram showing a further embodiment according to the present invention;
Figure 14 is a block diagram showing another embodiment according to the present invention;
Figure 15 is a block diagram showing another embodiment according to the present invention;
Figure 16 is a block diagram showing other embodiment according to the present invention;
Figure 17 is a block diagram showing a prior art; and
Figure 18 is a block diagram showing another prior art.

### DETAILED DESCRIPTION OF THE PREFERRED EMBODIMENTS

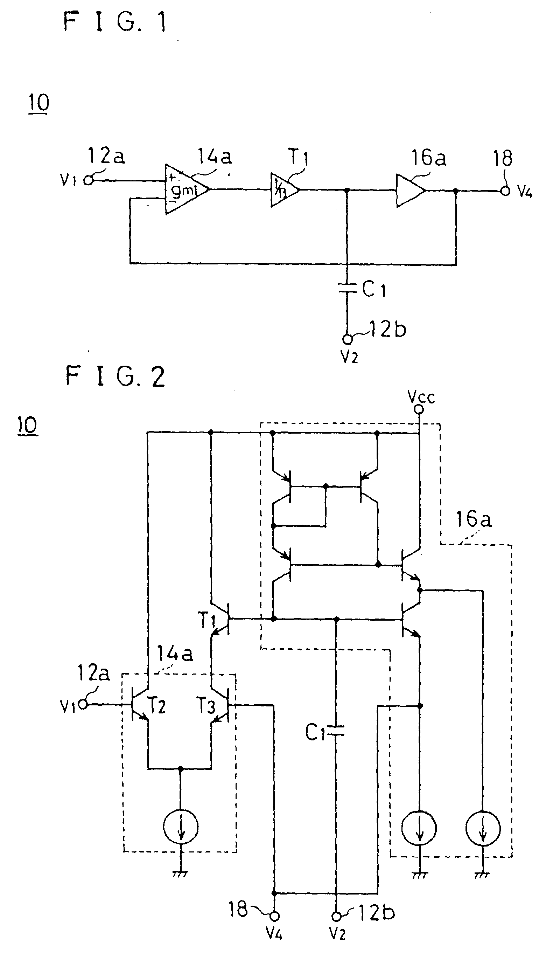

With referring Figure 1, a filter circuit 10̸ of this embodiment shown includes input terminals 12a and 12b, and the input terminal 12a is connected to a non-inverted input terminal of a differential amplifier 14a having a mutual conductance of gₘ₁. An output terminal of the differential amplifier 14a is connected to an output terminal 18 via a transistor T₁ having an attenuation rate of 1/β and a buffer 16a, and the input terminal 12b is connected to an output terminal of the transistor T₁ via a capacitor C₁. Furthermore, an output terminal of the buffer 16a is connected to an inverted input terminal of the differential amplifier 14a. Then, a signal is inputted from one of the input terminals 12a and 12b, and a signal subjected to a filtering process is outputted from the output terminal 18.

Next, an equivalent circuit diagram of the filter circuit 10̸ shown in Figure 1 is shown in Figure 2. An input from the input terminal 12a is applied to a base of a transistor T₂ included in a differential amplifier 14a, and an output from the buffer 16a is fed-back to a base of a transistor T₃. Therefore, a current in proportion to a difference between base inputs of the transistors T₂ and T₃ is outputted from the differential amplifier 14a, and the current flows between a collector and an emitter of the transistor T₁. Therefore, a current of 1/β of an output current from the differential amplifier 14a is outputted from a base of the transistor T₁, and the same is inputted to the buffer 16a. Furthermore, an input from the input terminal 12b is also applied to the buffer 16a via the capacitor C₁. Then, the output of the buffer 16a is outputted from the output terminal 18, and fed-back to the base of the transistor T₃.

On the assumption that the inputs from the input terminals 12a and 12b are V₁ and V₂, respectively, and the output from the output terminal 18 is V₄, a transfer function of the filter circuit 10̸ can be represented by the following equation 6.${\text{V}}_{\text{4}} \text{=} \frac{\text{S ·} \frac{{\text{C}}_{\text{1}}}{{\text{g}}_{\text{m1}}} {\text{· β · V}}_{\text{2}} {\text{+ V}}_{\text{1}}}{\text{S ·} \frac{{\text{C}}_{\text{1}}}{{\text{g}}_{\text{m1}}} \text{· β + 1}}$

Furthermore, in view of the equation 6, a resonance frequency ω _{0̸} can be represented by the following equation 7.${\text{ω}}_{\text{0̸}} \text{=} \frac{{\text{g}}_{\text{m1}}}{{\text{C}}_{\text{1}}} \text{·} \frac{\text{1}}{\text{β}}$

By arranging the transistor T₁ at a stage succeeding to the differential amplifier 14a, as seen from the equation 7, it is possible to decrease the resonance frequency ω_{0̸} by 1/β times a resonance frequency at a time that no transistor T₁ is provided. Therefore, if the resonance frequency ω_{0̸} is made the same as the resonance frequency at the time that no transistor is provided, a capacitor of the capacitor C1 can be decreased 1/β times.

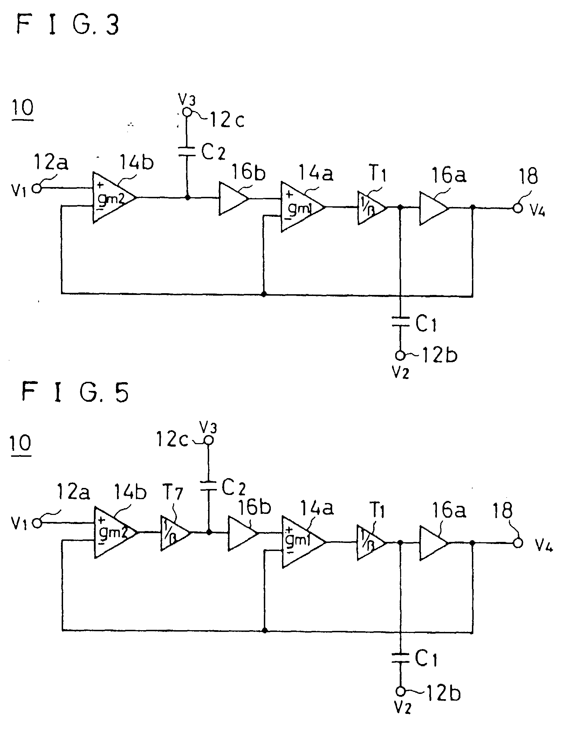

With referring Figure 3, a filter circuit 10̸ of another embodiment according to the present invention includes the input terminals 12a, 12b and 12c, and the input terminal 12a is connected to a non-inverted input terminal of a differential amplifier 14b having a mutual conductance of gₘ₂. An output terminal of the differential amplifier 14b is connected to a non-inverted input terminal of a differential amplifier 14a having a mutual conductance of gₘ₁ via a buffer 16b. To the output terminal of the differential amplifier 14b, the input terminal 12c is also connected via a capacitor C₂. An output terminal of the differential amplifier 14a is connected to an output terminal 18 via a transistor T₁ having an attenuation rate of 1/β and a buffer 16b, and to an output terminal of the transistor T₁, the input terminal 12b is connected via the capacitor C₁. Furthermore, an output terminal of the buffer 16a is connected to inverted input terminals of the differential amplifiers 14a and 14b. Then, a signal is inputted to any one of the input terminals 12a, 12b and 12c, and a signal subjected to a filtering process is outputted from the output terminal 18.

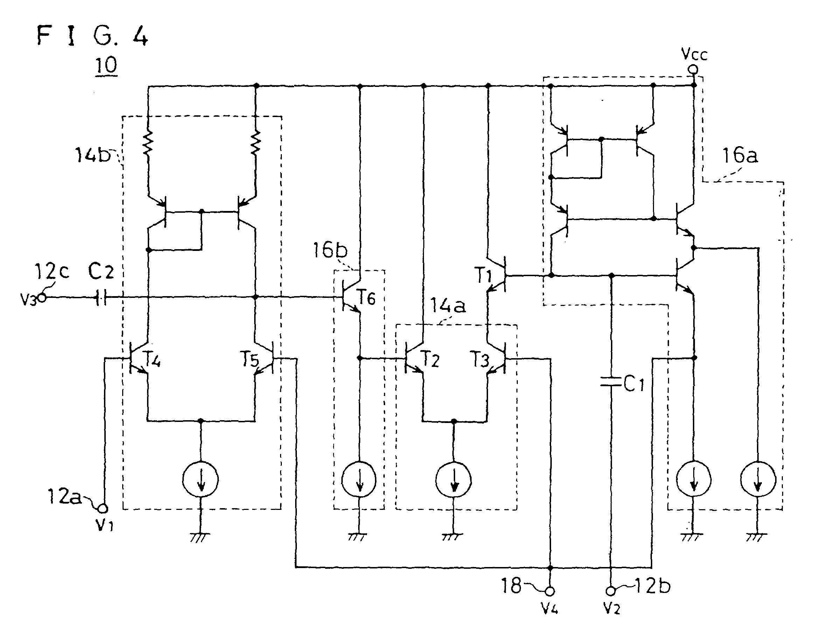

Next, an equivalent circuit diagram of the filter circuit 10̸ shown in Figure 3 is shown in Figure 4. An input from the input terminal 12a is applied to a transistor T₄ included in the differential amplifier 14b, and the output from the buffer 16a is fed-back to a transistor T₅ included in the differential amplifier 14b. Then, an output in proportion to a difference between these inputs is applied to a base of a transistor T₆ included in the buffer 16b. To the base of the transistor T₆, an input from the input terminal 12c is also applied via the capacitor C2. Then, a portion of an emitter current of the transistor T₆ is inputted to a base of the transistor T₂ included in the differential amplifier 14b, and the output of the buffer 16a is fed-back to a base of the transistor T₃ included in the differential amplifier 14a. Therefore, a current in proportion to a difference between base inputs of the transistors T₂ and T₃ is outputted from the differential amplifier 14a. The output current flows between a collector and an emitter of the transistor T₁, whereby a current of 1/β times the output current is outputted from the base of the transistor T₁. The base current is inputted to the buffer 16a. Furthermore, an input from the input terminal 12b is also applied to the buffer 16a via the capacitor C₂. Then, the output from the buffer 16a is outputted from the output terminal 18, and the same is fed-back to the bases of the transistors T₃ and T₅.

On the assumption that the inputs from the input terminals 12a, 12b and 12c are V₁, V₂ and V₃, respectively, and the output from the output terminal 18 is V₄, a transfer function of the filter circuit 10̸ can be represented by the following equation 8.${\text{V}}_{\text{4}} \text{=} \frac{{\text{S}}^{\text{2}} {\text{V}}_{\text{2}} \text{+ S ·} \frac{{\text{g}}_{\text{m1}}}{{\text{C}}_{\text{1}}} \text{·} \frac{\text{1}}{\text{β}} {\text{· V}}_{\text{3}} \text{+} \frac{{\text{g}}_{\text{m1}} {\text{· g}}_{\text{m2}}}{{\text{C}}_{\text{1}} {\text{· C}}_{\text{2}}} \text{·} \frac{\text{1}}{\text{β}} {\text{· V}}_{\text{1}}}{{\text{S}}^{\text{2}} \text{+ S ·} \frac{{\text{g}}_{\text{m1}}}{{\text{C}}_{\text{1}}} \text{·} \frac{\text{1}}{\text{β}} \text{+} \frac{{\text{g}}_{\text{m1}} {\text{· g}}_{\text{m2}}}{{\text{C}}_{\text{1}} {\text{· C}}_{\text{2}}} \text{·} \frac{\text{1}}{\text{β}}}$

Furthermore, in view of the equation 8, a resonance frequency ω _{0̸} and a quality factor Q are represented by the following equations 9 and 10̸, respectively.${\text{ω}}_{\text{0̸}} \text{=} \sqrt{\frac{{\text{g}}_{\text{m1}} {\text{· g}}_{\text{m2}}}{{\text{C}}_{\text{1}} {\text{· C}}_{\text{2}}} \text{·} \frac{\text{1}}{\text{β}}}$$\text{Q =} \sqrt{\frac{{\text{g}}_{\text{m2}} {\text{· C}}_{\text{1}}}{{\text{gm}}_{\text{1}} {\text{· C}}_{\text{2}}} \text{· β}}$

By arranging the transistor T₁ in a succeeding stage of the differential amplifier 14a, as seen from the equation 9, it is possible to decrease the resonance frequency ω _{0̸} by 1/√ β times a resonance frequency at a time that no transistor T₁ is provided. Furthermore, as seen from the equation 10̸, the quality factor Q can be increased by √ β times. Furthermore, if the capacitor of the capacitor C₂ is decreased by 1/ √ β times such that the resonance frequency ω _{0̸} is made as the same as the resonance frequency at the time that no transistor is provided, it is possible to reduce the capacity, and increase the quality factor Q by β times.

With referring 5, a filter circuit 10̸ of another embodiment according to the present invention includes structure approximately similar to that of the filter circuit 10̸ shown by Figure 3 and Figure 4 except that a transistor T₁ having an attenuation rate of 1/β is arranged in a stage succeeding to the differential amplifier 14b, and therefore, in the following, only a different point will be described, and a description of a similar point will be omitted.

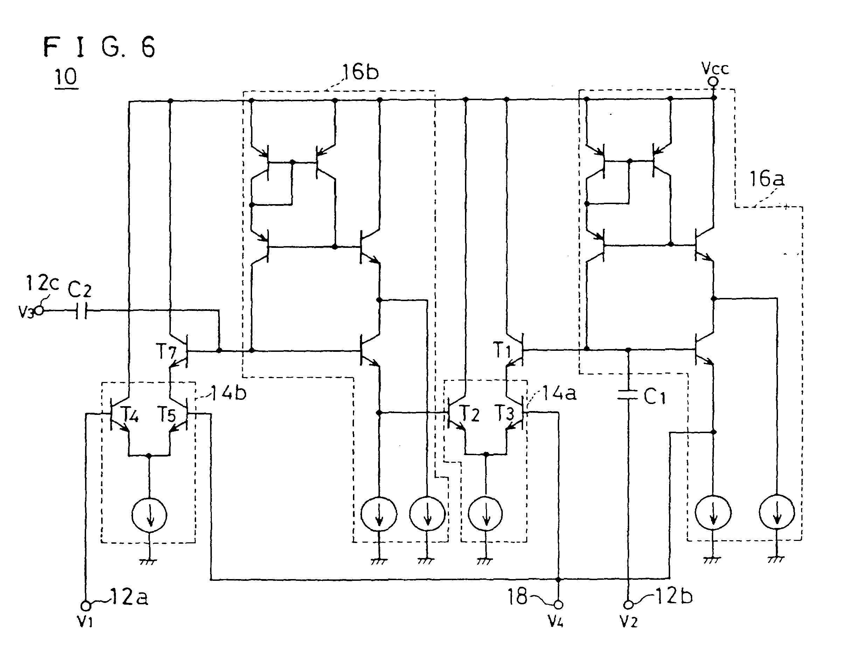

An equivalent circuit diagram of the filter circuit 10̸ shown in Figure 5 is shown in Figure 6. The output current from the differential amplifier 14b is passed through a collector and an emitter of the transistor T₇, whereby a current of 1/β times the output current from the differential amplifier 14b is outputted from a base of the transistor T₇. The base current and the input from the input terminal 12c are inputted to the buffer 16b, and the output from the buffer 16b is applied to the transistor T₂ included in the differential amplifier 14a.

A transfer function of the filter circuit 10̸ shown in Figure 5 is represented by the following equation 11.${\text{V}}_{\text{4}} \text{=} \frac{{\text{S}}^{\text{2}} {\text{V}}_{\text{2}} \text{+ S ·} \frac{{\text{g}}_{\text{m1}}}{{\text{C}}_{\text{1}}} \text{·} \frac{\text{1}}{\text{β}} {\text{· V}}_{\text{3}} \text{+} \frac{{\text{g}}_{\text{m1}} {\text{· g}}_{\text{m2}}}{{\text{C}}_{\text{1}} {\text{· C}}_{\text{2}}} \text{·} \frac{\text{1}}{{\text{β}}^{\text{2}}} {\text{· V}}_{\text{1}}}{{\text{S}}^{\text{2}} \text{+ S ·} \frac{{\text{g}}_{\text{m1}}}{{\text{C}}_{\text{1}}} \text{·} \frac{\text{1}}{\text{β}} \text{+} \frac{{\text{g}}_{\text{m1}} {\text{· g}}_{\text{m2}}}{{\text{C}}_{\text{1}} {\text{· C}}_{\text{2}}} \text{·} \frac{\text{1}}{{\text{β}}^{\text{2}}}}$

Furthermore, a resonance frequency ω _{0̸} and a quality factor Q can be represented by the following equations 12 and 13, respectively.${\text{ω}}_{\text{0̸}} \text{=} \sqrt{\frac{{\text{g}}_{\text{m1}} {\text{· g}}_{\text{m2}}}{{\text{C}}_{\text{1}} {\text{· C}}_{\text{2}}} \text{·} \frac{\text{1}}{{\text{β}}^{\text{2}}}}$$\text{Q =} \sqrt{\frac{{\text{g}}_{\text{m2}} {\text{· C}}_{\text{1}}}{{\text{g}}_{\text{m1}} {\text{· C}}_{\text{2}}}}$

By providing the transistors T₁ and T₇, it is impossible to make the quality factor Q large as seen from the equation 13; however, it is possible to decrease the resonance frequency ω _{0̸} by 1/β times as seen from the equation 12. In addition, if the capacity of the capacitor C₂ is decreased by 1/β times so as to make the resonance frequency ω _{0̸} the same as the resonance frequency at a time that no transistors T₁ and T₇ are provided, not only the capacity can be made small but also the quality factor Q can be increased by √ β times.

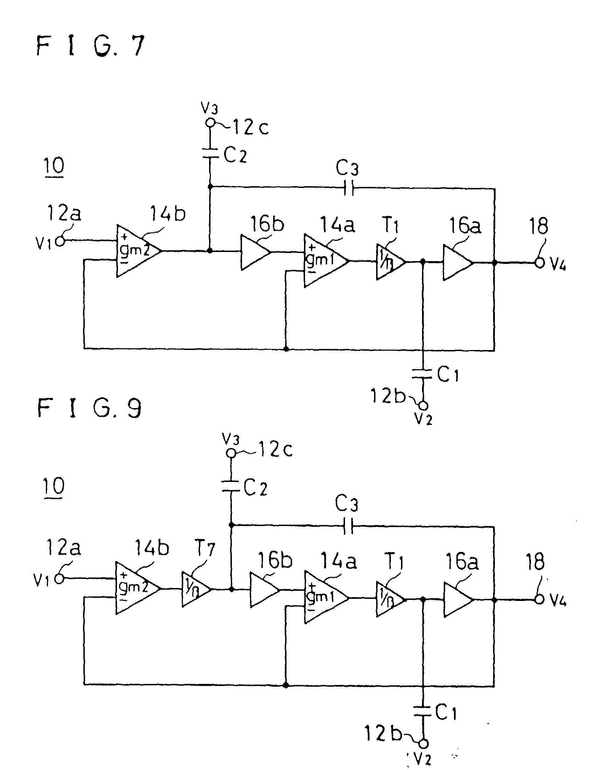

With referring Figure 7, a filter circuit 10̸ of another embodiment according to the present invention includes structure as the same as structure of the filter circuit 10̸ shown in Figure 7 except that a capacitor C₃ is inserted between one end of the capacitor C₂ and the output terminal of the buffer 16a, and therefore, in the following, only a different point will be described, and a description of a similar point will be omitted.

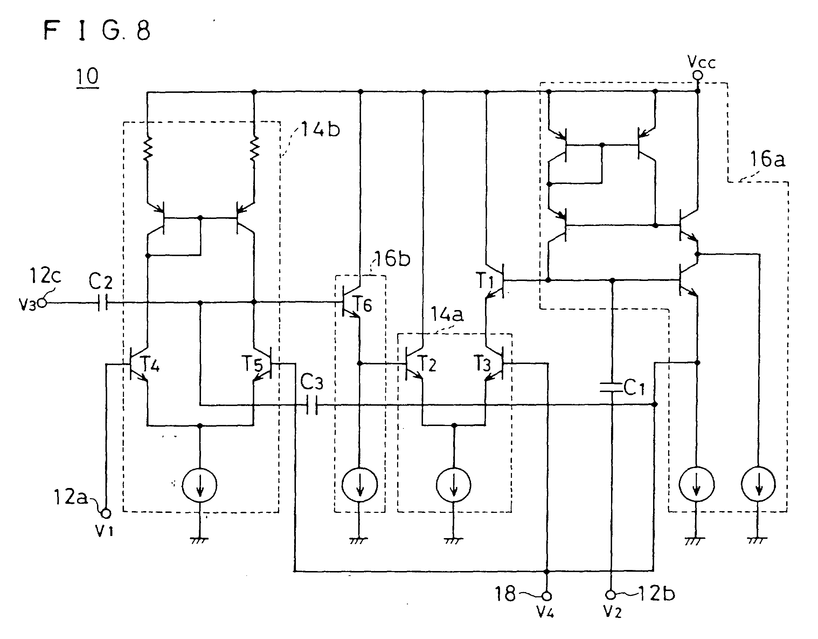

As seen from an equivalent circuit diagram shown in Figure 8, the capacitor C₃ is inserted between the output of the differential amplifier 14b and the output of the buffer 16a.

By adding the capacitor C₃, a transfer function of the filter circuit shown in Figure 7 can be represented by the following equation 14.${\text{V}}_{\text{4}} \text{=} \frac{{\text{S}}^{\text{2}} {\text{V}}_{\text{2}} \text{+ S ·} \frac{{\text{C}}_{\text{2}} {\text{· g}}_{\text{m1}}}{{\text{C}}_{\text{1}} {\text{(C}}_{\text{2}} {\text{+C}}_{\text{3}} \text{)}} \text{·} \frac{\text{1}}{\text{β}} {\text{· V}}_{\text{3}} \text{+} \frac{{\text{g}}_{\text{m1}} {\text{· g}}_{\text{m2}}}{{\text{C}}_{\text{1}} {\text{(C}}_{\text{2}} {\text{+C}}_{\text{3}} \text{)}} \text{·} \frac{\text{1}}{\text{β}} {\text{· V}}_{\text{1}}}{{\text{S}}^{\text{2}} \text{+ S ·} \frac{{\text{C}}_{\text{2}} {\text{· g}}_{\text{m1}}}{{\text{C}}_{\text{1}} {\text{(C}}_{\text{2}} {\text{+C}}_{\text{3}} \text{)}} \text{·} \frac{\text{1}}{\text{β}} \text{+} \frac{{\text{g}}_{\text{m1}} {\text{· g}}_{\text{m2}}}{{\text{C}}_{\text{1}} {\text{(C}}_{\text{2}} {\text{+C}}_{\text{3}} \text{)}} \text{·} \frac{\text{1}}{\text{β}}}$

A resonance frequency ω _{0̸} and a quality factor Q can be represented by the following equations 15 and 16, respectively.${\text{ω}}_{\text{0̸}} \text{=} \sqrt{\frac{{\text{g}}_{\text{m1}} {\text{· g}}_{\text{m2}}}{{\text{C}}_{\text{1}} {\text{(C}}_{\text{2}} {\text{+C}}_{\text{3}} \text{)}} \text{·} \frac{\text{1}}{\text{β}}}$$\text{Q =} \sqrt{\frac{{\text{g}}_{\text{m2}} {\text{· C}}_{\text{1}} {\text{(C}}_{\text{2}} {\text{+C}}_{\text{3}} \text{)β}}{{\text{g}}_{\text{m1}} {\text{·C}}_{\text{2}} {}^{\text{2}}}}$

As seen from the equation 15, it is possible to decrease the resonance frequency ω _{0̸} by 1/√ β times a resonance frequency at a time that no transistor T₁ is provided. Furthermore, as seen from the equation 16, it is possible to increase the quality factor Q by √ β times a quality factor at the time no transistor T₁ is provided. Furthermore, if the capacities of the capacitors C₂ and C₃ are decreased by 1/√ β times so as to make the resonance frequency ω _{0̸} the same as the resonance frequency at the time that no transistor T₁ is provided, not only the capacities can be made small but also the quality factor Q can be made further large.

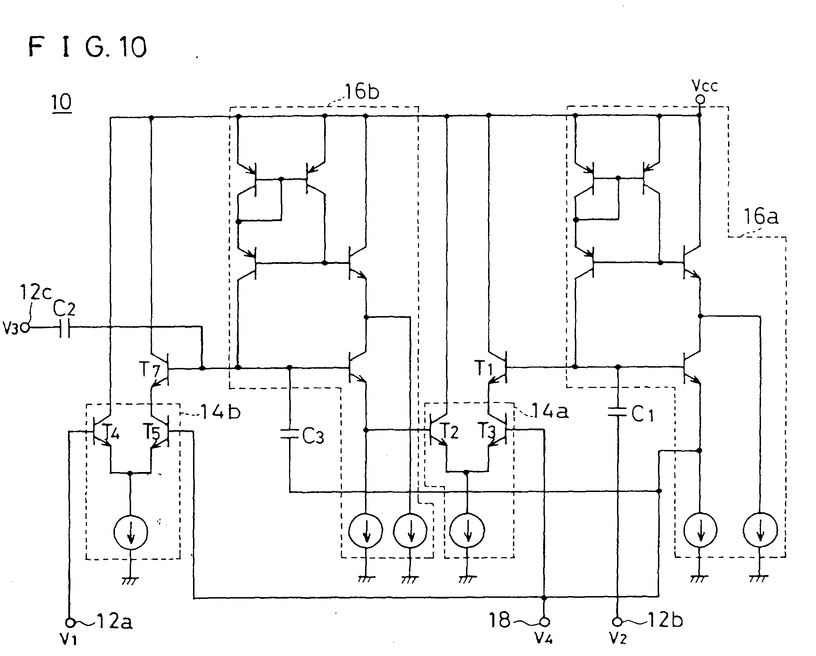

With referring Figure 9, a filter circuit 10̸ of another embodiment according to the present invention includes structure approximately similar to the structure of the filter circuit 10̸ shown in Figure 7, and therefore, in the following, only a different point will be described, and a description of a similar point will be omitted. The different point is a point that a transistor T₇ having an attenuation rate of 1/β is arranged at a stage succeeding to the differential amplifier 14b, and as seen from an equivalent circuit diagram of the filter circuit 10̸ shown in Figure 10̸, the transistor T₇ is connected to the collector of the transistor T₅ included in the differential amplifier 14b.

By adding such the transistor T₇, a transfer function of the filter circuit 10̸ shown in Figure 9 can be represented by the following equation 17.${\text{V}}_{\text{4}} \text{=} \frac{{\text{S}}^{\text{2}} {\text{V}}_{\text{2}} \text{+ S ·} \frac{{\text{C}}_{\text{2}} {\text{· g}}_{\text{m1}}}{{\text{C}}_{\text{1}} {\text{(C}}_{\text{2}} {\text{+C}}_{\text{3}} \text{)}} \text{·} \frac{\text{1}}{\text{β}} {\text{· V}}_{\text{3}} \text{+} \frac{{\text{g}}_{\text{m1}} {\text{· g}}_{\text{m2}}}{{\text{C}}_{\text{1}} {\text{(C}}_{\text{2}} {\text{+C}}_{\text{3}} \text{)}} \text{·} \frac{\text{1}}{{\text{β}}^{\text{2}}} {\text{· V}}_{\text{1}}}{{\text{S}}^{\text{2}} \text{+ S ·} \frac{{\text{C}}_{\text{2}} {\text{· g}}_{\text{m1}}}{{\text{C}}_{\text{1}} {\text{(C}}_{\text{2}} {\text{+C}}_{\text{3}} \text{)}} \text{·} \frac{\text{1}}{\text{β}} \text{+} \frac{{\text{g}}_{\text{m1}} {\text{· g}}_{\text{m2}}}{{\text{C}}_{\text{1}} {\text{(C}}_{\text{2}} {\text{+C}}_{\text{3}} \text{)}} \text{·} \frac{\text{1}}{{\text{β}}^{\text{2}}}}$

A resonance frequency ω _{0̸} and a quality factor Q can be represented by the following equations 18 and 19, respectively.${\text{ω}}_{\text{0̸}} \text{=} \sqrt{\frac{{\text{g}}_{\text{m1}} {\text{· g}}_{\text{m2}}}{{\text{C}}_{\text{1}} {\text{(C}}_{\text{2}} {\text{+C}}_{\text{3}} \text{)}} \text{·} \frac{\text{1}}{{\text{β}}^{\text{2}}}}$$\text{Q =} \sqrt{\frac{{\text{g}}_{\text{m2}} {\text{· C}}_{\text{1}} {\text{(C}}_{\text{2}} {\text{+C}}_{\text{3}} \text{)}}{{\text{g}}_{\text{m1}} {\text{·C}}_{\text{2}} {}^{\text{2}}}}$

As seen from the equation 19, the quality factor Q becomes the same as a quality factor at a time that no transistors T₁ and T₇ are provided; however, the resonance frequency ω _{0̸} becomes, as seen from the equation 18, 1/β of a quality factor at the time that no transistors T₁ and T₇ are provided. In addition, if the capacities of the capacitors C₂ and C₃ are made be 1/β so as to make the resonance frequency ω _{0̸} the same as the resonance frequency at the time no transistors T₁ and T₇ are provided, it is possible to make the capacities small, and the quality factor Q large.

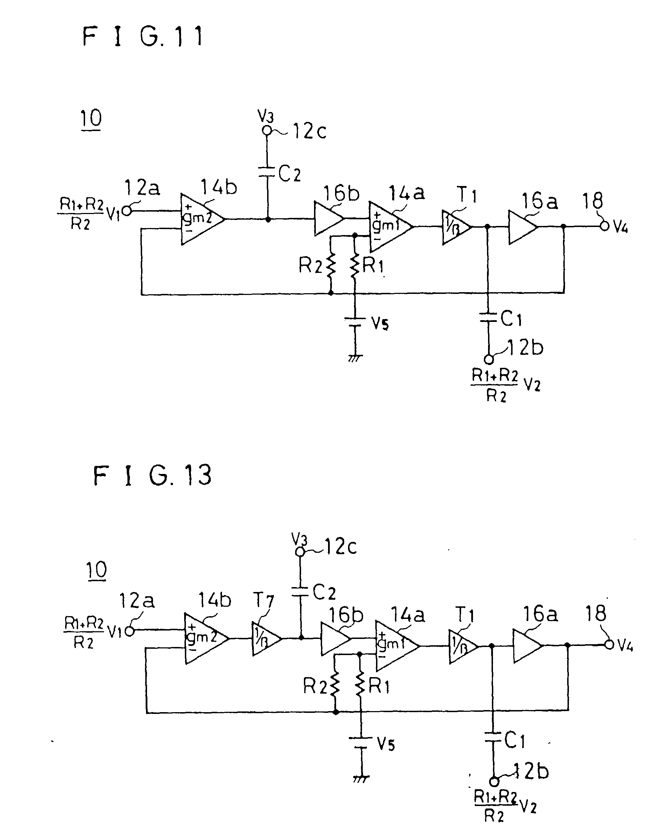

With referring Figure 11, a filter circuit 10̸ of another embodiment according to the present invention includes input terminals 12a, 12b and 12c, and the input terminal 12a is connected to a non-inverted input terminal of a differential amplifier 14b having a mutual conductance of gₘ₂. Furthermore, an output terminal of the differential amplifier 14b is connected to a non-inverted input terminal of a differential amplifier 14a having a mutual conductance of gₘ₁ via a buffer 16b, and an output terminal of the differential amplifier 14a is connected to an output terminal 18 via a transistor T₁ having an attenuation rate of 1/β and a buffer 16a. Furthermore, an output terminal of the buffer 16a is directly connected to an inverted input terminal of the differential amplifier 14b, and connected to the non-inverted input terminal of the differential amplifier 14a via a resistor R₂. A direct current voltage source V₅ is also connected to the inverted input terminal of the differential amplifier 14a via a resistor R₁. Furthermore, the input terminal 12c is connected to an output terminal of the differential amplifier 14b via a capacitor C₂, and the input terminal 12b is connected to an output terminal of the transistor T₁ via a capacitor C₁. Then, a signal is inputted from any one of the input terminals 12a, 12b and 12c, and a signal subjected to a filtering process is outputted from the output terminal 18.

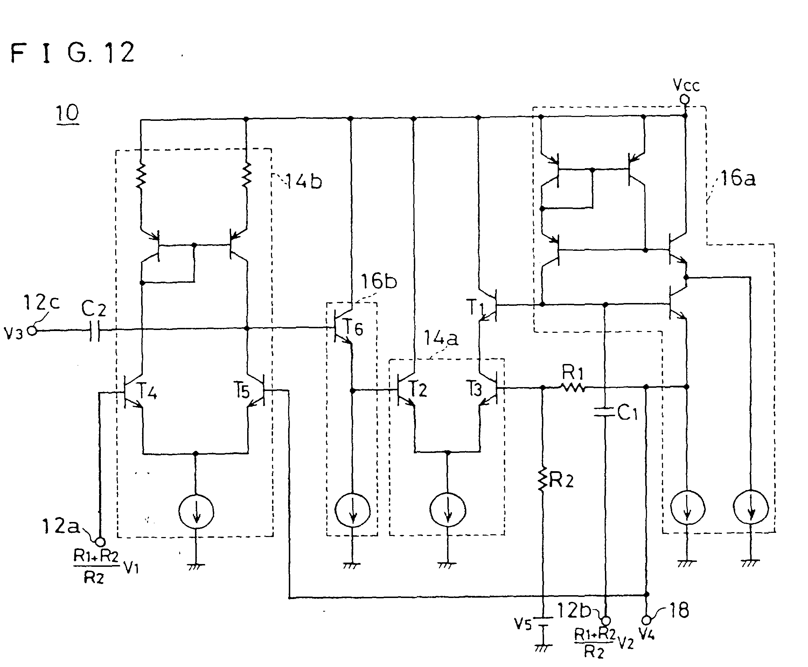

An equivalent circuit diagram of the filter circuit 10̸ is shown in Figure 12. An input from the input terminal 12a is applied to a transistor T₄ included in the differential amplifier 14b, and a feeding-back output from the buffer 16a is inputted to a transistor T₅ included in the differential amplifier 14b. Therefore, an output in proportion to a difference between the two inputs is inputted to a transistor T₆ included in the buffer 16b. To the transistor T₈, an input signal from the input terminal 12c is also applied through the capacitor C₂. The output from the buffer 16b according to these inputs is inputted to the transistor T₂ included in the differential amplifier 14a. The feeding-back output from the buffer 16a and an output from the direct current voltage source V₅ are inputted to the transistor T₃ included in the differential amplifier 14a through the resistors R₁ and R₂, respectively, and an output in proportion to a difference between these inputs is inputted to the transistor T₁. That is, an output current of the differential amplifier 14a flows between a collector and an emitter of the transistor T₁, whereby a current of 1/β times the output current from the differential amplifier 14a is outputted from a base of the transistor T₁, and the same is inputted to the buffer 16a. An input from the input terminal 12b is also applied to the buffer 16a through the capacitor C₁. Then, the output from the buffer 16a is outputted from the output terminal 18, and fed-back to the differential amplifiers 14a and 14b.

On the assumption that the inputs from the input terminals 12a, 12b and 12c are (R₁ + R₂)V₁/R₂, (R₁ + R₂)V₂/R₂ and V₃, respectively, and the output from the output terminal 18 is V₄, a transfer function of the filter circuit 10̸ of this embodiment shown can be represented by the following equation 2m0̸.${\text{V}}_{\text{4}} \text{=} \frac{{\text{R}}_{\text{1}} {\text{+ R}}_{\text{2}}}{{\text{R}}_{\text{2}}} \text{·} \frac{{\text{S}}^{\text{2}} {\text{V}}_{\text{2}} \text{+S ·} \frac{{\text{R}}_{\text{2}}}{{\text{R}}_{\text{1}} {\text{+R}}_{\text{2}}} \text{·} \frac{{\text{g}}_{\text{m1}}}{{\text{C}}_{\text{1}}} \text{·} \frac{\text{1}}{\text{β}} {\text{·V}}_{\text{3}} \text{+} \frac{{\text{g}}_{\text{m1}} {\text{· g}}_{\text{m2}}}{{\text{C}}_{\text{1}} {\text{·C}}_{\text{2}}} \text{·} \frac{\text{1}}{\text{β}} {\text{· V}}_{\text{1}}}{{\text{S}}^{\text{2}} \text{+ S ·} \frac{{\text{R}}_{\text{2}}}{{\text{R}}_{\text{1}} {\text{+R}}_{\text{2}}} \text{·} \frac{{\text{g}}_{\text{m1}}}{{\text{C}}_{\text{1}}} \text{·} \frac{\text{1}}{\text{β}} \text{+} \frac{{\text{g}}_{\text{m1}} {\text{· g}}_{\text{m2}}}{{\text{C}}_{\text{1}} {\text{· C}}_{\text{2}}} \text{·} \frac{\text{1}}{\text{β}}}$

Furthermore, a resonance frequency ω _{0̸} and a quality factor Q can be also represented by the following equations 20̸ and 21, respectively.${\text{ω}}_{\text{0̸}} \text{=} \sqrt{\frac{{\text{g}}_{\text{m1}} {\text{· g}}_{\text{m2}}}{{\text{C}}_{\text{1}} {\text{·C}}_{\text{2}}} \text{·} \frac{\text{1}}{\text{β}}}$$\text{Q =} \frac{{\text{R}}_{\text{1}} {\text{+ R}}_{\text{2}}}{{\text{R}}_{\text{2}}} \text{·} \sqrt{\frac{{\text{g}}_{\text{m2}} {\text{· C}}_{\text{1}}}{{\text{g}}_{\text{m1}} {\text{· C}}_{\text{2}}} \text{· β}}$

As seen from the equation 21, by adding the transistor T₁, it is possible to decrease the resonance frequency ω _{0̸} by 1/√ β times a resonance frequency at a time that no transistor T₁ is provided. Furthermore, as seen from the equation 22, the quality factor Q can be increased by √ β times a quality factor at the time that no transistor T₁ is provided. Furthermore, if the capacity of the capacitor C₂ is decreased by 1/√ β times so as to make the resonance frequency ω_{0̸} as the same as a resonance frequency at a time that no transistor T₁ is added, it is possible to increase the quality factor Q by β times.

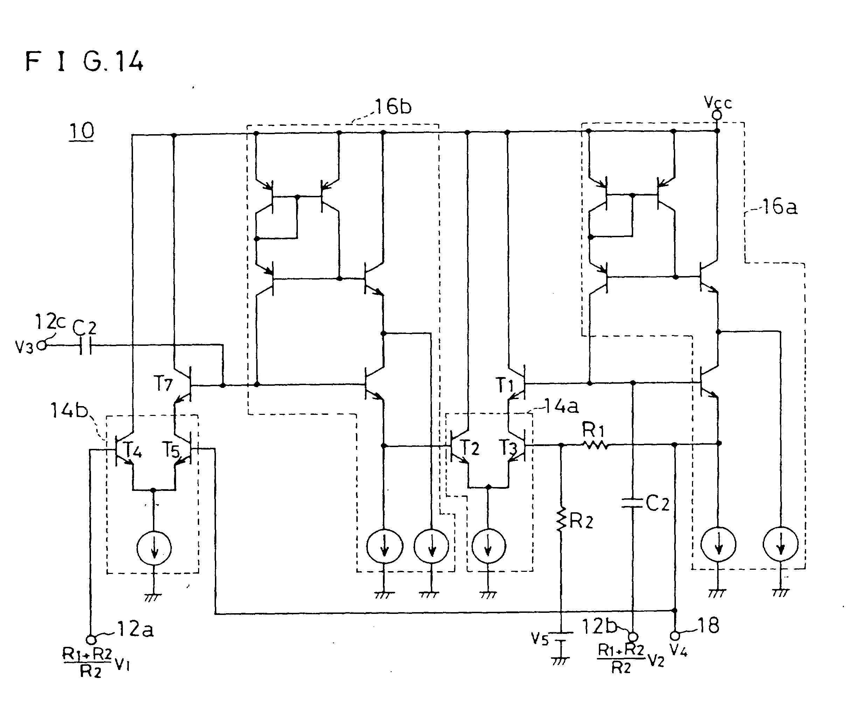

With referring to Figure 13, a filter circuit 10̸ of another embodiment according to the present invention is approximately similar to the filter circuit 10̸ shown in Figure 11, and therefore, only a different point will be described, and a description of a similar point will be omitted here. A transistor T₇ having an attenuation rate of 1/β is arranged at a stage succeeding to the differential amplifier 14b, and as seen from an equivalent circuit diagram of the filter circuit 10̸ shown in Figure 14, the transistor is arranged at a collector of the transistor T₅ included in the differential amplifier 14b. Therefore, the output current of the differential amplifier 14b is made be 1/β by transistor T₇, and an output current from the transistor T₇ is inputted to the buffer 16b.

Therefore, a transfer function of the filter circuit 10̸ of this embodiment shown can be represented by the following equation 23.${\text{V}}_{\text{4}} \text{=} \frac{{\text{R}}_{\text{1}} {\text{+ R}}_{\text{2}}}{{\text{R}}_{\text{2}}} \text{·} \frac{{\text{S}}^{\text{2}} {\text{V}}_{\text{2}} \text{+S ·} \frac{{\text{R}}_{\text{2}}}{{\text{R}}_{\text{1}} {\text{+R}}_{\text{2}}} \text{·} \frac{{\text{g}}_{\text{m1}}}{{\text{C}}_{\text{1}}} \text{·} \frac{\text{1}}{\text{β}} {\text{·V}}_{\text{3}} \text{+} \frac{{\text{g}}_{\text{m1}} {\text{· g}}_{\text{m2}}}{{\text{C}}_{\text{1}} {\text{·C}}_{\text{2}}} \text{·} \frac{\text{1}}{{\text{β}}^{\text{2}}} {\text{· V}}_{\text{1}}}{{\text{S}}^{\text{2}} \text{+ S ·} \frac{{\text{R}}_{\text{2}}}{{\text{R}}_{\text{1}} {\text{+R}}_{\text{2}}} \text{·} \frac{{\text{g}}_{\text{m1}}}{{\text{C}}_{\text{1}}} \text{·} \frac{\text{1}}{\text{β}} \text{+} \frac{{\text{g}}_{\text{m1}} {\text{· g}}_{\text{m2}}}{{\text{C}}_{\text{1}} {\text{· C}}_{\text{2}}} \text{·} \frac{\text{1}}{{\text{β}}^{\text{2}}}}$

Then, in view of the equation 23, a resonance frequency ω _{0̸} and a quality factor Q are represented by the equations 24 and 25, respectively.${\text{ω}}_{\text{0̸}} \text{=} \sqrt{\frac{{\text{g}}_{\text{m1}} {\text{· g}}_{\text{m2}}}{{\text{C}}_{\text{1}} {\text{·C}}_{\text{2}}} \text{·} \frac{\text{1}}{{\text{β}}^{\text{2}}}}$$\text{Q =} \frac{{\text{R}}_{\text{1}} {\text{+ R}}_{\text{2}}}{{\text{R}}_{\text{2}}} \text{·} \sqrt{\frac{{\text{g}}_{\text{m2}} {\text{· C}}_{\text{1}}}{{\text{g}}_{\text{m1}} {\text{· C}}_{\text{2}}}}$

As seen from the equations 24 and 25, by adding the transistors T₁ and T₇, the quality factor Q becomes not to be changed in comparison with a case where the transistors T₁ and T₇ are not added; however, it is possible to decrease the resonance frequency ω _{0̸} by 1/β times the resonance frequency of the case where no transistor T₁ and the transistor T₇ are added. However, if the capacity of the capacitor C₂ is decreased by 1/β times such that the resonance frequency ω _{0̸} is made be the same as the resonance frequency at a time that no transistors T₁ and T₇ are added, it is possible to increase the quality factor Q by β times.

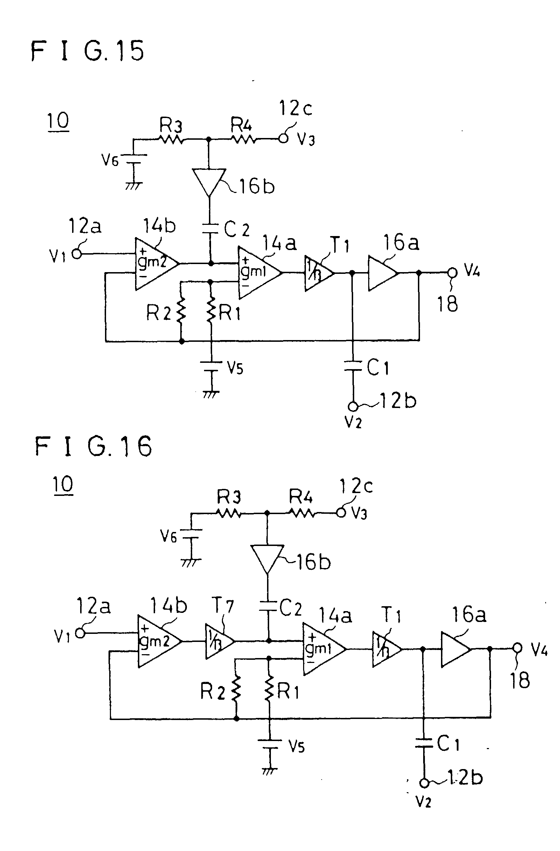

In addition, in the filter circuits 10̸ shown in Figure 11 and Figure 13, the inputs from the input terminals 12a and 12b are made be(R₁ + R₂)/R₂·V₁ and ((R₁ + R₂)/R₂·V₂ , and therefore, an amplifier (not shown) is required to be provided in a stage preceding to the input terminals 12a and 12b. In order to solve such a problem, the filter circuit may be constructed as shown in Figure 15 and Figure 16. That is, resisters R₃ and R₄ are connected in parallel to one end of the capacitor C₂ via the buffer 16b, and the resistor R₃ and the resistor R₄ may be connected to a direct current voltage source V₆ and the input terminal 12c, respectively.

In the filter circuit 10̸ thus constructed, if the inputs from the input terminals 12a, 12b and 12c are V₁, V₂ and V₃, respectively. A transfer function of the filter circuit 10̸ shown in Figure 13 becomes to be represented by the following equation 26.${\text{V}}_{\text{4}} \text{=} \frac{{\text{S}}^{\text{2}} {\text{V}}_{\text{2}} \text{+ S ·} \frac{{\text{R}}_{\text{3}}}{{\text{R}}_{\text{3}} {\text{+R}}_{\text{4}}} \text{·} \frac{{\text{g}}_{\text{m1}}}{{\text{C}}_{\text{1}}} \text{·} \frac{\text{1}}{\text{β}} {\text{· V}}_{\text{3}} \text{+} \frac{{\text{g}}_{\text{m1}} {\text{· g}}_{\text{m2}}}{{\text{C}}_{\text{1}} {\text{·C}}_{\text{2}}} \text{·} \frac{\text{1}}{\text{β}} {\text{· V}}_{\text{1}}}{{\text{S}}^{\text{2}} \text{+ S ·} \frac{{\text{R}}_{\text{2}}}{{\text{R}}_{\text{1}} {\text{+R}}_{\text{2}}} \text{·} \frac{{\text{g}}_{\text{m1}}}{{\text{C}}_{\text{1}}} \text{·} \frac{\text{1}}{\text{β}} \text{+} \frac{{\text{g}}_{\text{m1}} {\text{· g}}_{\text{m2}}}{{\text{C}}_{\text{1}} {\text{·C}}_{\text{2}}} \text{·} \frac{\text{1}}{\text{β}}}$

Now, if R₂/(R₁ + R₂) = R₃/(R₃ + R₄) , the equation 26 can be represented by the following equation 27, and in view of the equation 27, the resonance frequency ω_{0̸} and the quality factor Q are represented by the following equations 28 and 29, respectively.${\text{V}}_{\text{4}} \text{=} \frac{{\text{S}}^{\text{2}} {\text{V}}_{\text{2}} \text{+ S ·} \frac{{\text{R}}_{\text{2}}}{{\text{R}}_{\text{1}} {\text{+R}}_{\text{2}}} \text{·} \frac{{\text{g}}_{\text{m1}}}{{\text{C}}_{\text{1}}} \text{·} \frac{\text{1}}{\text{β}} {\text{· V}}_{\text{3}} \text{+} \frac{{\text{g}}_{\text{m1}} {\text{· g}}_{\text{m2}}}{{\text{C}}_{\text{1}} {\text{·C}}_{\text{2}}} \text{·} \frac{\text{1}}{\text{β}} {\text{· V}}_{\text{1}}}{{\text{S}}^{\text{2}} \text{+ S ·} \frac{{\text{R}}_{\text{2}}}{{\text{R}}_{\text{1}} {\text{+R}}_{\text{2}}} \text{·} \frac{{\text{g}}_{\text{m1}}}{{\text{C}}_{\text{1}}} \text{·} \frac{\text{1}}{\text{β}} \text{+} \frac{{\text{g}}_{\text{m1}} {\text{· g}}_{\text{m2}}}{{\text{C}}_{\text{1}} {\text{·C}}_{\text{2}}} \text{·} \frac{\text{1}}{\text{β}}}$${\text{ω}}_{\text{0̸}} \text{=} \sqrt{\frac{{\text{g}}_{\text{m1}} {\text{· g}}_{\text{m2}}}{{\text{C}}_{\text{1}} {\text{·C}}_{\text{2}}} \text{·} \frac{\text{1}}{\text{β}}}$$\text{Q =} \frac{{\text{R}}_{\text{1}} {\text{+ R}}_{\text{2}}}{{\text{R}}_{\text{2}}} \text{·} \sqrt{\frac{{\text{g}}_{\text{m2}} {\text{· C}}_{\text{1}}}{{\text{g}}_{\text{m1}} {\text{· C}}_{\text{2}}} \text{· β}}$

Accordingly, it will be understood that the equations 28 and 29 are the same as the equations 21 and 22.

Furthermore, as to the filter circuit 10̸ shown in Figure 14, if R₂/(R₁ + R₂ ) = R₃/(R₃ + R₄), the transfer function can be represented by the following equation 30̸, and the resonance frequency ω _{0̸} and the quality factor Q can be represented by the following equations 31 and 32.${\text{V}}_{\text{4}} \text{=} \frac{{\text{S}}^{\text{2}} {\text{V}}_{\text{2}} \text{+ S ·} \frac{{\text{R}}_{\text{2}}}{{\text{R}}_{\text{1}} {\text{+R}}_{\text{2}}} \text{·} \frac{{\text{g}}_{\text{m1}}}{{\text{C}}_{\text{1}}} \text{·} \frac{\text{1}}{\text{β}} {\text{· V}}_{\text{3}} \text{+} \frac{{\text{g}}_{\text{m1}} {\text{· g}}_{\text{m2}}}{{\text{C}}_{\text{1}} {\text{·C}}_{\text{2}}} \text{·} \frac{\text{1}}{{\text{β}}^{\text{2}}} {\text{· V}}_{\text{1}}}{{\text{S}}^{\text{2}} \text{+ S ·} \frac{{\text{R}}_{\text{2}}}{{\text{R}}_{\text{1}} {\text{+R}}_{\text{2}}} \text{·} \frac{{\text{g}}_{\text{m1}}}{{\text{C}}_{\text{1}}} \text{·} \frac{\text{1}}{\text{β}} \text{+} \frac{{\text{g}}_{\text{m1}} {\text{· g}}_{\text{m2}}}{{\text{C}}_{\text{1}} {\text{·C}}_{\text{2}}} \text{·} \frac{\text{1}}{{\text{β}}^{\text{2}}}}$${\text{ω}}_{\text{0̸}} \text{=} \sqrt{\frac{{\text{g}}_{\text{m1}} {\text{· g}}_{\text{m2}}}{{\text{C}}_{\text{1}} {\text{·C}}_{\text{2}}} \text{·} \frac{\text{1}}{{\text{β}}^{\text{2}}}}$$\text{Q =} \frac{{\text{R}}_{\text{1}} {\text{+ R}}_{\text{2}}}{{\text{R}}_{\text{2}}} \text{·} \sqrt{\frac{{\text{g}}_{\text{m2}} {\text{· C}}_{\text{1}}}{{\text{g}}_{\text{m1}} {\text{· C}}_{\text{2}}}}$

Accordingly, it will be understood that the equations 31 and 32 are the same as the equations 24 and 25.

Although the present invention has been described and illustrated in detail, it is clearly understood that the same is by way of illustration and example only and is not to be taken by way of limitation, the scope of the present invention being limited only by the terms of the appended claims.

## Claims

1. A filter circuit which comprises first, second and third terminals (12a, 12b 18);
a first operational amplifier (14a) having a first input and a second input respectively connected to the first (12a) and the third terminals (12b), and an output current path; and a first capacitor (C₁) connected between the output current path and the second terminal (12b), and when an input signal is applied from at least one of the first terminal and the second terminal, an output signal is obtained from the third terminal
**characterized** in that
said filter circuit further comprises a first current attenuation means (T₁) connected between the output current path and the first capacitor, said first current attenuation means supplying a current smaller than the output current of the first operational amplifier to the first capacitor.

2. A filter circuit according to claim 1, further comprising:
a second operational amplifier (14b) having a first input and a second input respectively connected to the first terminal (12a) and the third terminal (18), and an output connected to the first input of the first operational amplifier (14a)
a fourth terminal (12c); and
a second capacitor (C₂) connected between the first input of the first operational amplifier (14a) and the fourth terminal, wherein when an input signal is applied from at least one of the first terminal, the second terminal (12b) and the fourth terminal (12c), an output signal is obtained from the third terminal (18).

3. A filter circuit according to claim 2, further comprising a second current attenuation means (T₇) which is connected between an output of the second operational amplifier (14b) and a connection point of the fourth terminal and the first input of the first operational amplifier (14a), and attenuates an output current of the second operational amplifier.

4. A filter circuit according to claim 2 or 3, further comprising a third capacitor (C₃) connected between the third terminal (18) and the output of the second operational amplifier (14b).

5. A filter circuit according to claim 2 or 3, further comprising:
a direct current voltage source (V₅);
a first resistor (R₁) connected between the direct current voltage source and the second input of the first operational amplifier (14a); and
a second resistor (R₂) connected between the third terminal (18) and the second input of the first operational amplifier (14a).

6. A filter circuit according to claim 2 or 3, further comprising:
first (V₅) and second (V₆) direct current voltage sources;
a first resistor connected between the first direct current voltage source (V₅) and the second input of the first operational amplifier (14a);
a second resistor (R₂) connected between the third terminal (18) and the second input of the first operational amplifier (14a);
a third resistor (R₃) connected between the second direct current voltage (V₆) source and the second capacitor; and
a fourth resistor (R₄) connected between the fourth terminal (12c) and the second capacitor (C₂).

7. A filter circuit according to any one of claims 1 to 6, wherein at least one of said first current attenuation means (T₁) and said second current attenuation means (T₇) is a transistor circuit which attenuates an input current by 1/β (β is a current amplification factor).

## Patentansprüche

1. Filterschaltung, welche aufweist:
einen ersten, einen zweiten und einen dritten Anschluß (12a, 12b, 18);
einen ersten Operationsverstärker (14a), bei dem ein erster Eingang und ein zweiter Eingang jeweils mit dem ersten (12a) und dem dritten Anschluß (18) verbunden ist und der einen Ausgangsstromweg hat; und
einen ersten Kondensator (C₁), der zwischen dem Ausgangsstromweg und dem zweiten Anschluß (12b) geschaltet ist, und wobei, wenn ein Eingangssignal von mindestens einem der ersten und zweiten Anschlüsse zugeführt wird, ein Ausgangssignal von dem dritten Anschluß gewonnen wird,
dadurch **gekennzeichnet,** daß
die Filterschaltung weiterhin eine erste Stromabschwächungseinrichtung (T₁) aufweist, die zwischen dem Ausgangsstromweg und dem ersten Kondensator geschaltet ist, wobei die erste Stromabschwächungseinrichtung einen Strom, der kleiner als der Ausgangsstrom des ersten Operationsverstärkers ist, dem ersten Kondensator zuführt.

2. Filterschaltung nach Anspruch 1, welche weiterhin aufweist:
einen zweiten Operationsverstärker (14b), bei dem ein erster Eingang und ein zweiter Eingang jeweils mit dem ersten Anschluß (12a) und dem dritten Anschluß (18) verbunden ist und ein Ausgang mit der ersten Eingang des ersten Operationsverstärkers (14a) verbunden ist;
einen vierten Anschluß (12c); und
einen zweiten Kondensator (C₂), der zwischen dem ersten Eingang des ersten Operationsverstärkers (14a) und dem vierten Anschluß geschaltet ist, wobei, wenn ein Eingangssignal von mindestens dem ersten Anschluß, dem zweiten Anschluß (12b) und/oder dem vierten Anschluß (12c) zugeführt wird, ein Ausgangssignal von dem dritten Anschluß (18) gewonnen wird.

3. Filterschaltung nach Anspruch 2, welche weiterhin eine zweite Stromabschwächungseinrichtung (T₇) aufweist, die zwischen einem Ausgang des zweiten Operationsverstärkers (14b) und einem Verbindungspunkt des vierten Anschlusses und des ersten Eingangs des ersten Operationsverstärkers (14a) geschaltet ist und einen Ausgangsstrom des zweiten Operationsverstärkers abschwächt.

4. Filterschaltung nach Anspruch 2 oder 3, welche weiterhin einen dritten Kondensator (C₃) aufweist, der zwischen dem dritten Anschluß (18) und dem Ausgang des zweiten Operationsverstärkers (14b) geschaltet ist.

5. Filterschaltung nach Anspruch 2 oder 3, welche weiterhin aufweist:
eine Gleichspannungsquelle (V₅) ;
einen ersten Widerstand (R₁), der zwischen der Gleichspannungsquelle und dem zweiten Eingang des ersten Operationsverstärkers (14a) geschaltet ist; und
einen zweiten Widerstand (R₂), der zwischen dem dritten Anschluß (18) und dem zweiten Eingang des ersten Operationsverstärkers (14a) geschaltet ist.

6. Filterschaltung nach Anspruch 2 oder 3, welche weiterhin aufweist:
eine erste (V₅) und eine zweite (V₆) Gleichspannungsquelle;
einen ersten Widerstand, der zwischen der ersten Gleichspannungsquelle (V₅) und dem zweiten Eingang des ersten Operationsverstärkers (14a) geschaltet ist;
einen zweiten Widerstand (R₂), der zwischen dem dritten Anschluß (18) und dem zweiten Eingang des ersten Operationsverstärkers (14a) geschaltet ist;
einen dritten Widerstand (R₃), der zwischen der zweiten Gleichspannungsquelle (V₆) und dem zweiten Kondensator geschaltet ist; und
einen vierten Widerstand (R₄), der zwischen dem vierten Anschluß (12c) und dem zweiten Kondensator (C₂) geschaltet ist.

7. Filterschaltung nach einem der Ansprüche 1 bis 6, bei welcher mindestens eines von dem ersten Stromabschwächungsmittel (T₁) und dem zweiten Stromabschwächungsmittel (T₇) eine Transistorschaltung ist, die einen Eingangsstrom um 1/β abschwächt (β ist ein Stromverstärkungsfaktor).

## Revendications

1. Circuit de filtrage comprenant des première, seconde et troisième bornes (12a, 12b, 18);
un premier amplificateur asservi (14a) ayant une première entrée et une seconde entrée raccordées respectivement auxdites première (12a) et troisième bornes (18), ainsi qu'un parcours de courant de sortie; et
un premier condensateur (C₁) raccordé entre ledit parcours de courant de sortie et ladite seconde borne (12b), et dans lequel, lorsqu'un signal d'entrée est fourni à partir d'au moins l'une desdites première et seconde bornes, un signal de sortie est obtenu de ladite troisième borne,
**caractérisé** en ce que
ledit circuit de filtrage comprend en outre un premier moyen d'atténuation de courant (T₁) raccordé entre ledit parcours de courant de sortie et ledit premier condensateur, ledit premier moyen d'atténuation de courant fournissant un courant, inférieur au courant de sortie dudit premier amplificateur asservi, audit premier condensateur.

2. Circuit de filtrage selon la revendication 1, comprenant en outre:
un second amplificateur asservi (14b) ayant une première entrée et une seconde entrée raccordées respectivement auxdites première (12a) et ladite troisième borne (18), et une sortie raccordée à la première entrée dudit premier amplificateur asservi (14a);
une quatrième borne (12c); et
un second condensateur (C₂) raccordé entre la première entrée dudit premier amplificateur asservi (14a) et ladite quatrième borne, dans lequel, lorsqu'un signal d'entrée est fourni à partir d'au moins l'une desdites première borne, seconde borne (12b) et quatrième borne (12c), un signal de sorti est obtenu de ladite troisième borne (18).

3. Circuit de filtrage selon la revendication 2 ou 3, comprenant en outre un second moyen d'atténuation de courant (T₇) qui est raccordé entre une sortie dudit second amplificateur asservi (14b) et un point de raccordement de ladite quatrième borne et de la première entrée dudit premier amplificateur asservi (14a), et qui atténue un courant de sortie dudit second amplificateur asservi.

4. Circuit de filtrage selon la revendication 2 ou 3, comprenant en outre un troisième condensateur (C₃) raccordé entre ladite troisième borne (18) et la sortie dudit second amplificateur asservi (14b).

5. Circuit de filtrage selon la revendication 2 ou 3, comprenant en outre:
une source de tension continue (V₅) ;
une première résistance (R₁) raccordée entre ladite source de tension continue et la seconde entrée dudit premier amplificateur asservi (14a); et
une seconde résistance (R₂) raccordée entre ladite troisième borne (18) et la seconde entrée dudit premier amplificateur asservi (14a).

6. Circuit de filtrage selon la revendication 2 ou 3, comprenant en outre:
des première (V₅) et seconde (V₆) sources de tension continue;
une première résistance raccordée entre ladite première source de tension continue (V₅) et la seconde entrée dudit premier amplificateur asservi (14a);
une seconde résistance (R₂) raccordée entre la troisième borne (18) et la seconde entrée dudit premier amplificateur asservi (14a);
une troisième résistance (R₃) raccordée entre la seconde source de tension continue (V₆) et ledit second condensateur; et
une quatrième résistance (R₄) raccordée entre ladite quatrième borne (12c) et ledit second condensateur (C₂).

7. Circuit de filtrage selon l'une quelconque des revendications 1 à 6, dans lequel au moins l'un desdits premier moyen d'atténuation de courant (T₁) et second moyen d'atténuation de courant (T₇) est un circuit de transistor atténuant un courant d'entrée par 1/β (β est un facteur d'amplification de courant).
